# EUROPÄISCHE PATENTANMELDUNG

(11) **EP 1 628 342 A1**
(43) Veröffentlichungstag der Anmeldung: **22.02.2006**
(21) Anmeldenummer: 05017747.6
(22) Anmeldetag: 16.08.2005
(51) Int. Cl.: H01L 23/367, H01L 23/467

(54) **Kühlkörper und Kühlkörperanordnung**

(30) Priorität: 16.08.2004 DE 102004040557
(71) Anmelder: Kern, Dietmar, Dr., 90455 Nürnberg (DE)
(72) Erfinder: Kern, Dietmar, Dr., 90455 Nürnberg (DE)
(74) Vertreter: Blaumeier, Jörg

(57) **Zusammenfassung**

Kühlkörper mit horizontalen und/oder vertikalen Kühlrippen zur Entwärmung von Baugruppen oder Bauteilen, insbesondere zur Kühlung elektronischer Bauelemente, dadurch gekennzeichnet, dass bei einer Rippendicke > 0,2 mm entweder
- bei einer Rippenhöhe (h) von bis zu oder gleich 10 mm das Verhältnis der Rippenhöhe (h) zur mittleren Rippenbreite (b) größer als sechs ist, oder
- bei einer Rippenhöhe (h) von mehr als 10 mm das Verhältnis der Rippenhöhe (h) zur mittleren Rippenbreite (b) größer als elf ist.

## Beschreibung

Die Erfindung betrifft einen Kühlkörper mit horizontalen und/oder vertikalen Kühlrippen zur Entwärmung von Baugruppen oder Bauteilen, insbesondere zur Kühlung elektronischer Bauelemente.

Derartige Kühlkörper werden zum Beispiel zur Kühlung elektronischer Bauelemente in der Leistungselektronik von Hausgeräten, Kochgeräten und insbesondere von Induktionsherden eingesetzt. Um eine optimale Wärmeabfuhr zu erzielen, werden die geometrischen Verhältnisse des Kühlkörpers so festgelegt, dass sich ein besonders kleiner Wärmewiderstand bei einem niedrigen Kühlkörpergewicht ergibt.

Kühlkörper für die Kühlung von elektronischen Bauelementen sind hinlänglich bekannt. Sie werden in vielfältigster Gestalt für die unterschiedlichsten Anwendungen mit und ohne eine besondere Zuführung von Kühlluft eingesetzt.

Aus dem Patent US 6 422 307 B1 ist ein Kühlkörper für elektronische Bauteile bekannt, der eine Vielzahl von extrem dünnen, einzelnen, in Reihen und Spalten angeordneten senkrechten Kühlrippen aufweist.

In dem Patent US 6 515 862 B1 wird ein Kühlkörper für einen Mikroprozessor beschrieben, der eine Vielzahl von gebogenen, parallel zueinander angeordneten Kühlrippen aufweist.

In dem Patent US 6 424 528 B1 wird ein Kühlkörper für Mikroprozessoren vorgeschlagen, der aus einer Matrix von einzelnen Kühlrippen besteht. Um die Ableitung der Wärme zu verbessern, ist ein heat pipe vorgesehen, das mit Wasser oder anderen Substanzen gefüllt werden kann.

Traditionell kommen vor allem bei größeren Kühlleistungen sehr voluminöse Kühlkörper zum Einsatz, deren Kühlrippenhöhe im Verhältnis zu ihrer Breite in der Regel um 7 bis 10 beträgt. Ähnliche Verhältnisse bestehen bei dem Verhältnis von Rippenhöhe zu Rippenabstand mit Werten um etwa 4 bis 5. Diese Verhältnisse führen zu Kühlkörpern, die bezogen auf ihren Wärmewiderstand ein großes Gewicht haben.

Auf der anderen Seite werden zunehmend Forderungen nach leistungsfähigeren Elektronikkühlkörpern gestellt, die im Rahmen dieser Auslegungsgepflogenheiten nicht mehr realisierbar sind, ohne dass Nachteile bei anderen Betriebsparametern in Kauf genommen werden müssen. So führt zum Beispiel eine mögliche Erhöhung der Strömungsgeschwindigkeit der Kühlluft bei einem gegebenen Kühlkörper nicht nur zu kleineren Wärmewiderständen, sondern auch zu entsprechend lauteren Geräuschen oder eine Vergrößerung der Kühlkörper zu einem höheren Volumen/Gewicht und zu mehr Kosten.

Der Erfindung liegt daher das Problem zugrunde, einen Kühlkörper zu schaffen, der einen kleinen Wärmewiderstand bei niedrigem Volumen und damit Gewicht aufweist.

Zur Lösung dieses Problems ist ein Kühlkörper mit den Merkmalen des Anspruchs 1 vorgesehen.

Gemäß der ersten im Patentanspruch 1 aufgeführten Alternative ist bei einer Rippenhöhe (h) von bis zu 10 mm das Verhältnis der Rippenhöhe (h) zur mittleren Rippenbreite (b) größer als 6. Gemäß der zweiten im Patentanspruch 1 aufgeführten Alternative ist bei einer Rippenhöhe (h) von mehr als 10 mm das Verhältnis der Rippenhöhe (h) zur mittleren Rippenbreite (b) größer als 11. In beiden Fällen ist die Rippendicke > 0,2 mm.

Der Erfindung liegt die Erkenntnis zugrunde, dass der angestrebte kleine Wärmewiderstand bei niedrigem Kühlkörpergewicht durch eine Verbesserung der Gestalt der Kühlrippen und ihrer Anordnungsdichte erzielt werden kann.

Erfindungsgemäß wird die Verbesserung durch deutlich schlankere Kühlrippen mit zusätzlich einem kleineren Abstand zwischen ihnen erreicht. Zu diesem Zweck haben die Kühlrippen mit der mittleren Dicke (Breite) b bei einer Höhe h bis zu einschließlich 10 mm ein Schlankheitsverhältnis h/b größer als 6 und bei einer Rippenhöhe über 10 mm ein solches größer als 11. Bei Kühlrippen gleicher Dicke ist das Schlankheitsverhältnis der Quotient aus Höhe h geteilt durch die Dicke b. Im Falle von im Wesentlichen keilförmigen oder trapezförmigen Kühlrippen ist die Dicke b der Mittelwert von größter und kleinster Dicke über ihre Höhe. Bei einer keilförmigen Basis ist die Rippenhöhe h die Höhe der Rippenmittellinie.

Der lichte Rippenabstand ist als Abstand a zwischen den Rippenmittellinien in der Mitte der Rippenhöhe zweier benachbarter Kühlrippen minus der Summe der halben mittleren Rippendicke der beiden benachbarten Rippen definiert. Für das Verhältnis von Rippenhöhe h zum lichten Rippenabstand a minus b erweist sich erfindungsgemäß ein Wert größer als 7 besonders vorteilhaft. Vorzugsweise ist der lichte Rippenabstand > 0,9 mm, die Rippenlänge ist vorzugsweise > 20 mm.

Eine besonders gute Kühlwirkung lässt sich erzielen, wenn der Kühlkörper, ggf. auch die daran oder darauf angebrachten elektronischen Bauelemente, zumindest teilweise von einem Luftführungskanal zur Kühlluftführung umschlossen ist bzw. sind. Durch diese Kühlluftführung kann der Luftstrom besonders kontrolliert geführt werden. Der Luftführungskanal kann gemäß einer Weiterbildung der Erfindung ein- oder mehrteilig ausgebildet sein und vorzugsweise ein unteres und ein oberes Profilelement umfassen. Das untere Profilelement kann dabei Bestandteil einer Wanne sein, in der z.B. eine Leiterplatte mit den elektronischen Bauelementen aufgenommen ist. Das obere Profilelement kann als Deckel ausgebildet sein.

Um besonders günstige Strömungsverhältnisse zu erzielen, können bei dem erfindungsgemäßen Kühlkörper die Querschnitte der Kühlrippen im Wesentlichen trapezförmig oder keilförmig ausgebildet sein. Es ist ebenfalls günstig, wenn der Grund des Kühlkanals zwischen benachbarten Kühlrippen abgerundet ausgebildet ist. In ähnlicher Weise kann auch die Spitze der Kühlrippen abgerundet ausgebildet sein.

Der erfindungsgemäße Kühlkörper eignet sich besonders für Hausgeräte oder Kochgeräte, insbesondere kann er in Induktionsherden eingebaut werden. Durch die vorgeschlagenen Verbesserungen ergibt sich der gewünschte kleine Wärmewiderstand bei geringem Kühlkörpergewicht, das wiederum in einem geringeren Materialverbrauch und entsprechenden Ersparnissen resultiert.

Daneben betrifft die Erfindung eine Kühlkörperanordnung, die dadurch gekennzeichnet ist, dass sie wenigstens einen Kühlkörper der beschriebenen Art und eine Lüftereinrichtung zur Zwangsbelüftung umfasst. Vorzugsweise kann die Lüftereinrichtung der erfindungsgemäßen Kühlkörperanordnung so angeordnet sein, dass der Kühlkörper im Wesentlichen parallel zu den Kühlrippen angeströmt wird. Durch die erfindungsgemäß vorgesehene besondere Gestaltung des Verhältnisses der Rippenhöhe zur mittleren Rippenbreite ergeben sich signifikante Verbesserungen der thermischen Eigenschaften, so dass ggf. eine Lüftereinrichtung mit geringerer Leistung ausreicht.

Weitere Vorteile und Einzelheiten der Erfindung werden anhand der nachfolgenden Beschreibung von Ausführungsbeispielen unter Bezugnahme auf die Figuren erläutert. Die Figuren sind schematische Darstellungen und zeigen:
Fig. 1a und 1b erfindungsgemäße Kühlkörper mit waagerechten Rippen;
Fig. 2a bis 2c erfindungsgemäße Kühlkörper mit senkrechten Rippen; und
Fig. 3 einen erfindungsgemäßen Kühlkörper in einem Luftführungskanal.

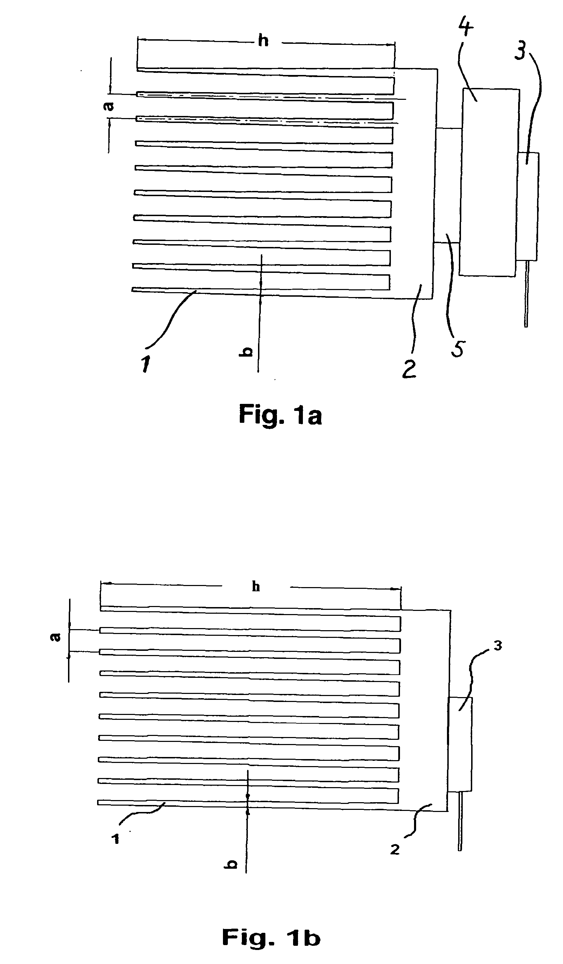

In Fig. 1a ist ein Elektronikkühlkörper mit wagrechten Rippen 1 und seitlich montiertem Leistungshalbleiter 3 dargestellt. Der Kühlkörper wird durch Extrudieren eines Profils hergestellt. Je nach Einsatzfall, Montagekonzept und Platzverhältnissen können ein oder mehrere elektronische Bauelemente 3 mit gleicher oder unterschiedlicher Verlustleistung auf einem Kopf 4 angebracht sein, der über einen Hals 5 mit einer Basis 2 des Kühlkörpers verbunden ist. Der Kopf ermöglicht je nach seiner Formgestaltung eine freie Wahl der Montageart und relativen Lage der zu kühlenden elektronischen Bauelemente.

Die Basis 2 ist mit Kühlrippen 1 in geeigneter Zahl und Größe ausgestattet. Ganz allgemein können weitere Kühlrippen sowohl am Kopf als auch am Hals angebracht sein. Die Rippen können in ihrer Länge ununterbrochen oder unterbrochen sein und/oder einen geraden oder gewellten Querschnitt aufweisen. Für die Erfindung ist es darüber hinaus ebenfalls ohne Bedeutung, wenn die zu kühlenden elektronischen Bauelemente 3 auch direkt auf der Basis 2 montiert sind, d. h. der Kühlkörper keinen speziellen Montage-Kopf aufweist, wie in Fig. 1 b gezeigt ist.

Die Kühlrippen 1 des in Fig. 1a gezeigten Kühlkörpers weisen einen keilförmigen Querschnitt auf. Der Querschnitt verjüngt sich dabei ausgehend von der Basis 2 zum freien Ende der Kühlrippen 1 hin. In dem dargestellten Ausführungsbeispiel ist die Rippenhöhe h größer als 10 mm. Das Verhältnis der Rippenhöhe h zur mittleren Rippenbreite b ist größer als 11. Bei anderen Ausgestaltungen kann der Kühlrippengrund abgerundet ausgebildet sein.

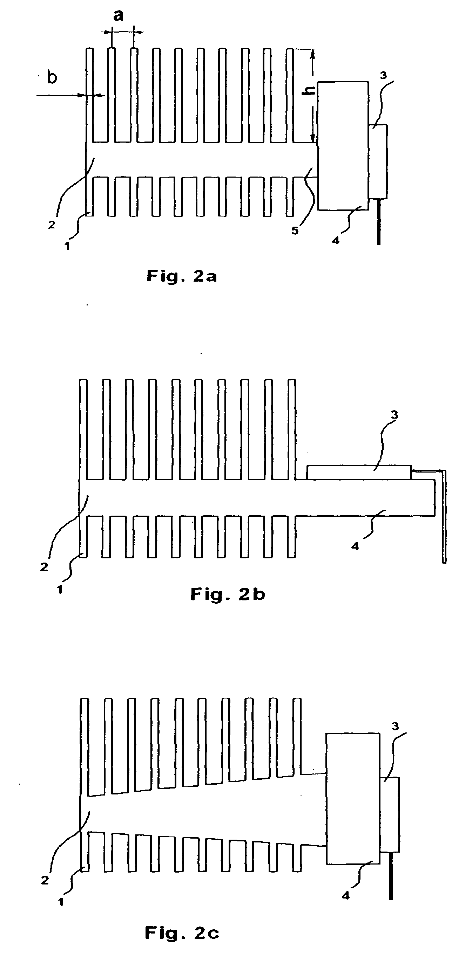

Das Kühlkörperprofil in den Fig. 2a bis 2c unterscheidet sich von Fig.1 in erster Linie dadurch, dass es vertikal angeordnete Kühlrippen 1 hat und dementsprechend die Basis 2 waagrecht liegt. Dies ändert aber nichts an den bereits erwähnten erfindungsgemäßen Gestaltungsgrundsätzen für die Kühlrippen. Je nach den geometrischen Verhältnissen des Kühlkörperquerschnitts hinsichtlich seiner Höhe und Breite kann die Basis 2 gleichdick oder keilförmig sein. Desgleichen kann die Ankoppelung der elektronischen Bauelemente 3 ähnlich wie bei einem Kühlkörper mit horizontalen Rippen 1 auf eine vielfältige Art und Weise erfolgen.

Besonders vorteilhaft ist es, wenn man zusätzlich die Luftströmung im Bereich des Kühlkörpers kontrolliert führt, in dem man den Kühlkörper - möglichst einschließlich seiner elektronischen Bauelemente - mit einem im Wesentlichen geschlossenen Luftführungskanal umgibt, der eine Kühlluftführung bildet und den Kühlkörper-querschnitt und seine auf ihm befestigten elektronischen Bauelemente möglichst eng umschließt.

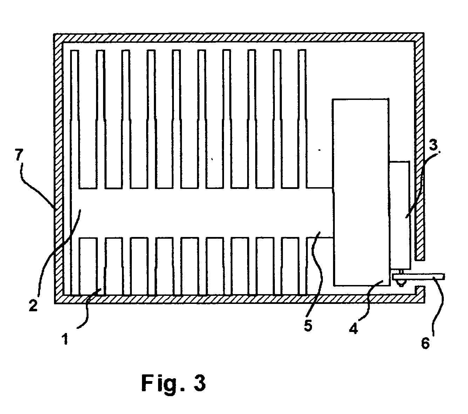

Fig. 3 zeigt als Beispiel einen Kühlkörper-Querschnitt nach Fig. 2a, der von einem Luftführungskanal 7 umgeben ist, der den Kühlkörper über seine ganze Länge hinweg weitgehend umschließt. Die strömungstechnisch wünschenswerte vollständige Umschließung des Kühlköperquerschnitts ist je nach dem Konstruktionskonzept des Gesamtsgeräts nicht immer ohne weiteres realisierbar oder zweckmäßig. Das gilt z. B. bei der auch aus Kostengründen einfachen Art und Weise der direkten oder indirekten Herausführung der Anschlüsse der durch den Kühlkörper zu kühlenden elektronischen Bauelemente über eine Leiterplatte 6 aus dem Luftführungskanal 7, so wie in Fig. 3 beispielhaft dargestellt.

Bei dem in Fig. 3 dargestellten Kühlkörper ist eine nicht dargestellte Lüftereinrichtung zur Zwangsbelüftung vorgesehen. Wie aus der Figur hervorgeht, wird der Kühlkörper im Wesentlichen parallel zu den Kühlrippen 1 angeströmt, senkrecht zu seinem vertikalen Querschnitt.

Der in Fig. 3 gezeigte Kühlkörper ist in einem Induktionsherd eingebaut. Derartige Kochgeräte umfassen eine Kunststoffwanne, in der unter anderem die Leistungselektronik für die Ansteuerung der Heizplatten angeordnet ist. Der in Fig. 3 gezeigte Kühlkanal 7 kann alternativ auch mehrteilig ausgebildet sein, wobei ein entsprechender Profilabschnitt der Kunststoffwanne den unteren Abschnitt und ein Deckel, etwa ein Aluminiumblechdeckel den oberen Profilabschnitt des Kühlkanals bildet. Die Kunststoffwanne und/oder der Deckel weist dabei Vorsprünge oder Stege auf, die als Trennwände dienen. Der Kühlkörper kann bei horizontalen Rippen eine senkrechte Stummelrippe am Ende der oberen Rippe aufweisen. Bei vertikalen Rippen kann die letzte Rippe nach oben verlängert sein. Der Aluminiumdeckel kann Längssicken aufweisen, um den Zwischenraum zwischen Kühlkörper und Aluminiumdeckel näherungsweise zu schließen.

## Patentansprüche

1. Kühlkörper mit horizontalen und/oder vertikalen Kühlrippen zur Entwärmung von Baugruppen oder Bauteilen, insbesondere zur Kühlung elektronischer Bauelemente, **dadurch gekennzeichnet, dass** bei einer Rippendicke > 0,2 mm entweder
- bei einer Rippenhöhe (h) von bis zu oder gleich 10 mm das Verhältnis der Rippenhöhe (h) zur mittleren Rippenbreite (b) größer als sechs ist, oder
- bei einer Rippenhöhe (h) von mehr als 10 mm das Verhältnis der Rippenhöhe (h) zur mittleren Rippenbreite (b) größer als elf ist.

2. Kühlkörper nach Anspruch 1, **dadurch gekennzeichnet, dass** das Verhältnis von Rippenhöhe (h) zum lichten Rippenabstand (a minus b) größer als sieben ist.

3. Kühlkörper nach Anspruch 1 oder 2, **dadurch gekennzeichnet, dass** der Querschnitt der Kühlrippen (1) im Wesentlichen trapezförmig oder keilförmig ausgebildet ist.

4. Kühlkörper nach einem der vorangehenden Ansprüche, **dadurch gekennzeichnet, dass** er mit oder ohne die daran oder darauf angebrachten elektronischen Bauelemente (3), zumindest teilweise von einem Luftführungskanal (7) zur Kühlluftführung umschlossen ist bzw. sind.

5. Kühlkörper nach Anspruch 4, **dadurch gekennzeichnet, dass** der Luftführungskanal (7) ein- oder mehrteilig ausgebildet ist und vorzugsweise ein unteres und ein oberes Profilelement umfasst.

6. Kühlkörper nach einem der vorangehenden Ansprüche, **dadurch gekennzeichnet, dass** der Grund des Kühlkanals zwischen benachbarten Kühlrippen (1) abgerundet ausgebildet ist.

7. Kühlkörper nach einem der vorangehenden Ansprüche, **dadurch gekennzeichnet, dass** die Spitze der Kühlrippen (1) abgerundet ausgebildet ist.

8. Kühlkörper nach einem der vorangehenden Ansprüche, **dadurch gekennzeichnet, dass** er in einem Hausgerät oder einem Kochgerät, insbesondere in einem Induktionsherd, einbaubar oder eingebaut ist.

9. Kühlkörperanordnung, **dadurch gekennzeichnet, dass** sie wenigstens einen Kühlkörper nach einem der Ansprüche 1 bis 8 und eine Lüftereinrichtung zur Zwangsbelüftung umfasst.

10. Kühlkörperanordnung nach Anspruch 9, **dadurch gekennzeichnet, dass** die Lüftereinrichtung derart angeordnet ist, dass der Kühlkörper im Wesentlichen parallel zu den Kühlrippen (1) angeströmt wird, senkrecht zu seinem vertikalen Querschnitt.
